# FASCICULE DE BREVET EUROPEEN

(11) **EP 3 501 908 B1**
(45) Date de publication et mention de la délivrance du brevet: **09.09.2020**
(21) Numéro de dépôt: 18210582.5
(22) Date de dépôt: 05.12.2018
(51) Int. Cl.: B60R 16/023

(54) **ÉQUIPEMENT ÉLECTRIQUE À PAROI DÉPORTÉE**
ELEKTRISCHE AUSRÜSTUNG MIT VERSETZTER WAND
ELECTRICAL EQUIPMENT WITH OFFSET WALL

(30) Priorité: 22.12.2017 FR 1762950
(43) Date de publication de la demande: 26.06.2019
(73) Titulaire: Valeo Siemens eAutomotive France SAS, 95800 Cergy (FR)
(72) Inventeur: TRAMET, Guillaume, 78920 Ecquevilly (FR); DENIOT, Roger, 78300 Poissy (FR)
(74) Mandataire: Argyma

(56) Documents cités:
- EP-A1- 1 870 969
- EP-A1- 3 002 999
- WO-A1-2013/102720
- WO-A1-2017/081245
- FR-A1- 2 979 177

## Description

### DOMAINE TECHNIQUE ET OBJET DE L'INVENTION

La présente invention se rapporte au domaine des équipements électriques haute tension pour véhicules électriques et hybrides et concerne plus particulièrement un élément de boîtier pour un équipement électrique, notamment pour véhicule électrique et hybride.

L'invention vise notamment à permettre une connexion fiable et sécurisée d'une batterie d'alimentation sur un équipement électrique.

### ETAT DE LA TECHNIQUE

Comme cela est connu, par exemple du document WO 2017/081245, un véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension. La batterie d'alimentation haute tension assure une fonction d'alimentation en énergie du système de motorisation électrique permettant la propulsion du véhicule. Plus précisément, afin de commander la machine électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

Dans une solution connue, l'onduleur se présente sous la forme d'un boîtier dans lequel sont montés un module électronique de puissance et une unité électronique de contrôle. Le module électronique de puissance comprend un corps comportant des composants électriques par lesquels passe l'énergie alimentant la machine électrique. L'unité électronique de contrôle comprend des composants électroniques permettant de contrôler le module électronique de puissance.

Par exemple, dans le cas où la machine électrique est un moteur électrique triphasé, le module électronique de puissance comprend trois conducteurs électriques, dits « conducteurs de phase », permettant de relier le module électronique de puissance au moteur électrique afin de le commander en utilisant trois courants dits « de phase » déphasés deux à deux, par exemple de 120°. Ces courants de phase sont générés par l'onduleur à partir du courant continu délivré par la batterie haute tension. Afin de connecter le module électronique de puissance à la batterie haute tension, l'onduleur comprend en outre un conducteur électrique destiné à être relié au potentiel positif de la batterie d'alimentation haute tension et un conducteur électrique destiné à être relié au potentiel négatif de la batterie d'alimentation haute tension.

Un module électronique de puissance peut être fourni avec plusieurs bornes positives et plusieurs bornes négatives destinées à recevoir un signal électrique à partir d'une source d'énergie électrique. Typiquement, le signal électrique est modifié par des composants de puissance du module électronique de puissance pour être délivré en sortie du module électronique de puissance. Cependant, dans certaines applications, il n'est pas nécessaire de délivrer des signaux électriques différents sur les couples de bornes positive/négative. Il est alors nécessaire de relier chaque paire de borne positive/négative à la même source d'énergie électrique. Entre la source d'énergie électrique, il faut donc utiliser un connecteur pour chaque borne. Ce qui complique la connexion du module électronique de puissance à la source d'énergie électrique.

De plus, l'intensité des courants pouvant circuler dans les conducteurs électriques reliés à la batterie d'alimentation haute tension étant relativement élevée, par exemple supérieur à 100 A, l'agencement desdits conducteurs électriques peut présenter un risque d'électrocution pour un opérateur qui manipulerait l'onduleur, notamment lors de la connexion ou la déconnexion de la batterie d'alimentation sur l'onduleur, ce qui présente un inconvénient majeur.

Il existe donc un besoin d'une solution simple de connexion d'un équipement électrique à une source d'énergie électrique.

### PRESENTATION GENERALE DE L'INVENTION

L'invention concerne un équipement électrique, notamment pour véhicule électrique ou hybride, comprenant un boîtier, ledit boîtier comprenant un élément de boîtier comprenant une paroi latérale et définissant un espace intérieur dans lequel sont montés :
- un module électronique de puissance comprenant une pluralité de paires de bornes externes positive et négative destinées à échanger une énergie d'alimentation avec une source d'énergie électrique,
- une barre de connexion électrique comportant un premier conducteur électrique et un deuxième conducteur électrique, le premier conducteur électrique comprenant des bornes en contact avec les bornes positives du module électronique de puissance, de manière à mettre les bornes positives au même potentiel électrique par l'intermédiaire du premier conducteur électrique, le deuxième conducteur électrique comprenant des bornes en contact avec les bornes négatives du module électronique de puissance, de manière à mettre les bornes négatives au même potentiel électrique par l'intermédiaire du deuxième conducteur électrique, au moins une desdites bornes du premier conducteur électrique, dite « borne apparente positive », et au moins une desdites bornes du deuxième conducteur électrique, dite « borne apparente négative », étant adaptées pour être reliées respectivement à une borne positive et à une borne négative d'une source d'énergie électrique, équipement électrique dans lequel la paroi latérale de l'élément de boîtier comprend un déport de matière vers son espace intérieur formant une zone de connexion de la borne positive et de la borne négative de la source d'énergie électrique de sorte que ledit déport de matière chevauche le premier conducteur électrique et le deuxième conducteur électrique en ne laissant apparaître, de l'extérieur de ladite paroi latérale, que la borne apparente positive et la borne apparente négative.

Ainsi, lorsque le module électronique de puissance et les conducteurs électriques sont montés dans l'élément de boîtier, la paroi latérale forme une ceinture entourant le module électronique de puissance et recouvrant en partie le premier conducteur électrique et le deuxième conducteur électrique de manière à ne laisser apparaître, à l'extérieur de ladite paroi latérale, qu'un seul élément de fixation de chacun des conducteurs électriques à une borne positive ou négative de la source d'énergie électrique, par exemple une batterie d'alimentation haute tension. La zone de connexion ainsi délimitée présente une surface restreinte qui réduit les risques de choc électrique pour un opérateur. Plus précisément, une première partie des bornes du premier conducteur sont à l'extérieur du boiter de manière à former au moins une borne externe de l'équipement électrique pour une connexion avec la source d'énergie électrique et une deuxième partie des bornes du premier conducteur sont à l'intérieur du boitier. De même, une première partie des bornes du deuxième conducteur sont à l'extérieur du boiter de manière à former au moins une borne externe de l'équipement électrique pour une connexion avec la source d'énergie électrique et une deuxième partie des bornes du deuxième conducteur sont à l'intérieur du boitier. L'agencement de l'espace intérieur défini par la paroi latérale permet ainsi de protéger la deuxième parties des bornes des conducteurs électriques de l'extérieur afin d'éviter à un opérateur de les toucher et de recevoir un choc électrique. Autrement dit, le déport de matière permet de ne faire apparaître de l'extérieur que la portion utile des conducteurs électriques de potentiel afin de réduire les risques de choc électrique. Les deuxièmes parties des bornes des conducteurs électriques sont dans l'espace intérieur du boitier, contrairement à l'art antérieur où elles sont à l'extérieur du boitier pour pouvoir être connectées à la source d'énergie électrique. De plus, un tel agencement de la paroi latérale permet d'augmenter le volume de l'espace interne de l'élément de boîtier de sorte qu'une unité électronique de contrôle peut s'étendre non seulement au-dessus du module électronique de puissance, mais également au-dessus du conducteur électrique de potentiel positif et du conducteur électrique de potentiel négatif. Dans l'équipement électrique selon l'invention, la barre de connexion électrique permet de relier ensemble d'une part, les bornes positives du module électronique de puissance, et d'autre part les bornes négatives du module électronique de puissance. Ainsi, il n'est pas nécessaire d'avoir un conducteur pour chaque borne positive ou négative du module électronique de puissance. Il suffit de connecter la borne apparente positive avec la borne positive de la source d'énergie électrique et la borne apparente négative avec la borne négative de la source d'énergie électrique de sorte que les bornes du module électronique de puissance reçoivent, via le premier conducteur électrique et le deuxième conducteur électrique le signal électrique généré par la source d'énergie électrique. Il est donc facile de connecter le module électronique de puissance à la source d'énergie électrique. En outre, on évite l'utilisation de plusieurs paires de connecteurs entre le module électronique de puissance et la source d'énergie électrique, ce qui réduit la résistance d'entrée du module électronique de puissance.

De préférence, la paroi latérale présente au moins en partie une forme de U, le déport de matière formant la zone de connexion correspondant à l'évidemment situé entre les branches du U.

De manière avantageuse, l'élément de boîtier comprend en outre une pluralité d'éléments de support reliant entre elles une pluralité de portions de la paroi latérale et permettant notamment le support du module électronique de puissance, du premier conducteur électrique et du deuxième conducteur électrique.

De préférence encore, l'élément de boîtier est monobloc, ce qui le rend solide, aisé à manipuler lors de l'assemblage et aisé à fabriquer, notamment par surmoulage.

Selon un aspect de l'invention, l'élément de boîtier étant réalisé en un matériau plastique, ce qui le rend léger, solide et aisé à fabriquer, notamment par surmoulage.

Avantageusement, la barre de connexion électrique comprend en outre une barre de fixation sur laquelle sont montés le premier conducteur électrique et le deuxième conducteur électrique.

Selon un aspect de l'invention, l'équipement électrique comprend en outre un couvercle fermant une face de la paroi latérale de l'élément de boîtier.

De manière avantageuse, l'équipement électrique comprend en outre une unité électronique de contrôle, ladite unité électronique de contrôle étant montée dans l'espace intérieur défini par la paroi latérale de l'élément de boîtier et étant configurée pour contrôler le module électronique de puissance, notamment afin qu'il convertisse un courant continu en au moins un courant alternatif.

Dans une forme de réalisation, l'équipement électrique est un onduleur destiné à être électriquement connecté, d'une part, à une machine électrique, notamment d'un véhicule électrique ou hybride et, d'autre part, à une batterie d'alimentation haute tension, notamment d'un véhicule électrique ou hybride.

Selon un aspect de l'invention, le module électronique de puissance est apte à convertir un courant continu en une pluralité de courants alternatifs dits « courants de phase ». Par les termes « module électronique de puissance apte à convertir un courant continu en une pluralité de courants alternatifs », on entend que le module électronique de puissance peut être configuré pour convertir un courant continu en une pluralité de courant alternatifs et/ou pour convertir une pluralité de courant alternatifs en un courant continu.

De manière préférée, le module de puissance comprend un corps.

Selon un aspect de l'invention, le premier conducteur électrique et le deuxième conducteur électrique sont montés sur le corps du module électronique de puissance.

L'invention concerne aussi un véhicule électrique ou hybride comprenant une machine électrique, par exemple une machine de motorisation, alimentée par une batterie d'alimentation haute tension via un réseau électrique embarqué haute tension et un équipement électrique, tel que présenté précédemment, connecté à ladite machine électrique.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
- la figure 1 est une vue en perspective d'une forme de réalisation d'un onduleur selon l'invention,
- la figure 2A est une vue partielle en perspective de l'ensemble formé du module électronique de puissance, de l'unité électronique de contrôle, du premier conducteur électrique de potentiel positif, du premier conducteur électrique de potentiel négatif et de la barre de fixation de l'onduleur de la figure 1,
- la figure 2B est une vue partielle en perspective du module électronique de puissance,
- la figure 3 est une vue en perspective de dessus de l'élément de boîtier de l'onduleur de la figure,
- la figure 4 est une vue en perspective de dessous de l'élément de boîtier de l'onduleur de la figure 1,
- la figure 5 est une vue en perspective de dessus de l'élément de boitier des figures 3 et 4 dans lequel est monté l'ensemble de la figure 2A et trois conducteurs de phase,
- la figure 6 est une vue en perspective de dessous de l'ensemble illustré à la figure 5,
- la figure 7 est une vue de dessus partielle de l'onduleur de la figure 1 montrant le montage de l'unité électronique de contrôle sur le module électronique de puissance.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite dans son application à un véhicule automobile électrique ou hybride sans que cela ne soit limitatif de la portée de la présente invention.

Dans l'exemple décrit ci-après, le véhicule comprend notamment une machine électrique, un équipement électrique se présentant sous la forme d'un onduleur, une batterie d'alimentation haute tension, un réseau électrique embarqué haute tension, une batterie d'alimentation basse tension, un réseau électrique embarqué basse tension et une pluralité d'équipements électriques auxiliaires.

L'équipement électrique selon l'invention est décrit ci-après dans sa mise en oeuvre pour un onduleur, sans toutefois que cela ne limite la portée de la présente invention. On notera ainsi que l'équipement électrique pourrait être autre chose qu'un onduleur, par exemple un chargeur ou un convertisseur DCDC embarqués dans le véhicule.

Le réseau électrique embarqué basse tension relie la batterie d'alimentation basse tension et la pluralité d'équipements électriques auxiliaires afin que la batterie d'alimentation basse tension alimente lesdits équipements électriques auxiliaires, tels que des calculateurs embarqués, des moteurs de lève-vitres, un système multimédia, etc. La batterie d'alimentation basse tension délivre typiquement par exemple une tension de l'ordre de 12 V, 24 V ou 48 V. La recharge de la batterie basse tension est réalisée à partir de la batterie haute tension via un convertisseur de tension continue en tension continue, appelé communément convertisseur continu-continu.

Le réseau électrique embarqué haute tension relie la batterie d'alimentation haute tension et l'onduleur afin que la batterie d'alimentation haute tension assure une fonction d'alimentation en énergie de la machine électrique via l'onduleur. La batterie d'alimentation haute tension délivre typiquement une tension comprise entre 100 V et 900 V, de préférence entre 100 V et 500 V. La recharge en énergie électrique de la batterie d'alimentation haute tension est réalisée en la connectant, via le réseau électrique haute tension continue du véhicule, à un réseau électrique externe, par exemple le réseau électrique alternatif domestique.

La machine électrique est une machine électrique tournante, de préférence destinée à entrainer les roues du véhicule à partir de l'énergie fournie par la batterie d'alimentation haute-tension. Plus précisément, la machine électrique est une machine électrique à courant alternatif alimentée par une source de courants polyphasés. Par exemple, la machine électrique peut être un moteur à courant alternatif. Dans l'exemple préféré décrit ci-après, la machine électrique est alimentée par une source de courants triphasés sans que cela ne soit limitatif de la portée de la présente invention.

Dans cet exemple, la commande de la machine électrique est réalisée au moyen de l'onduleur. Ledit onduleur permet de convertir le courant continu fourni par la batterie d'alimentation haute tension en trois courants de commande alternatifs, par exemple sinusoïdaux. Autrement dit, l'onduleur a pour fonction de transformer le courant continu délivré en entrée par la batterie d'alimentation haute tension en trois courants de phase permettant de commander la machine électrique. A l'inverse, dans un autre mode de fonctionnement, la machine électrique peut également fournir trois courants alternatifs à l'onduleur afin que ledit onduleur les transforme en un courant continu permettant de charger la batterie d'alimentation haute-tension.

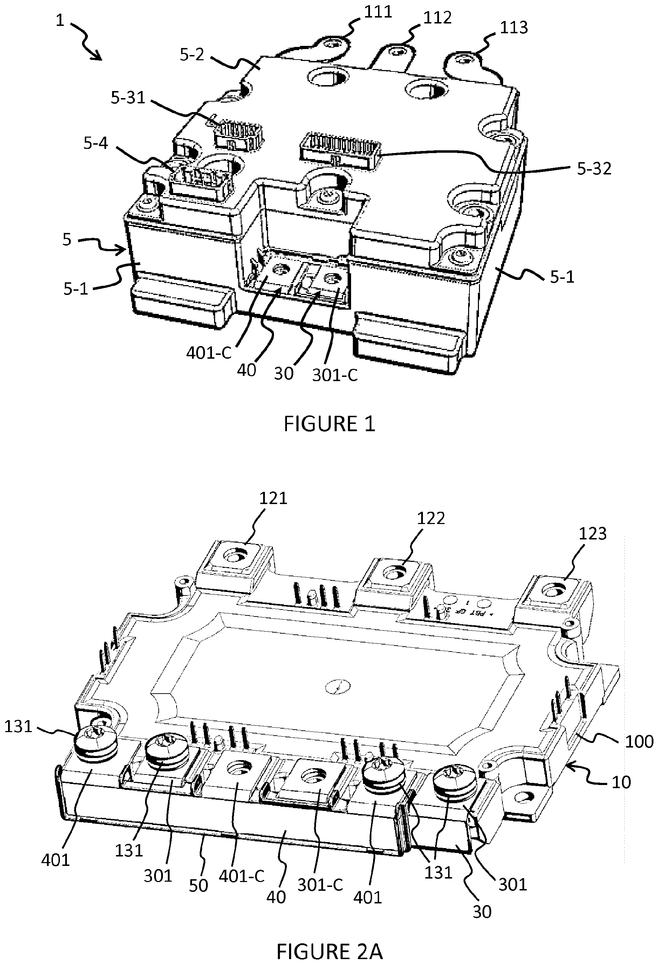

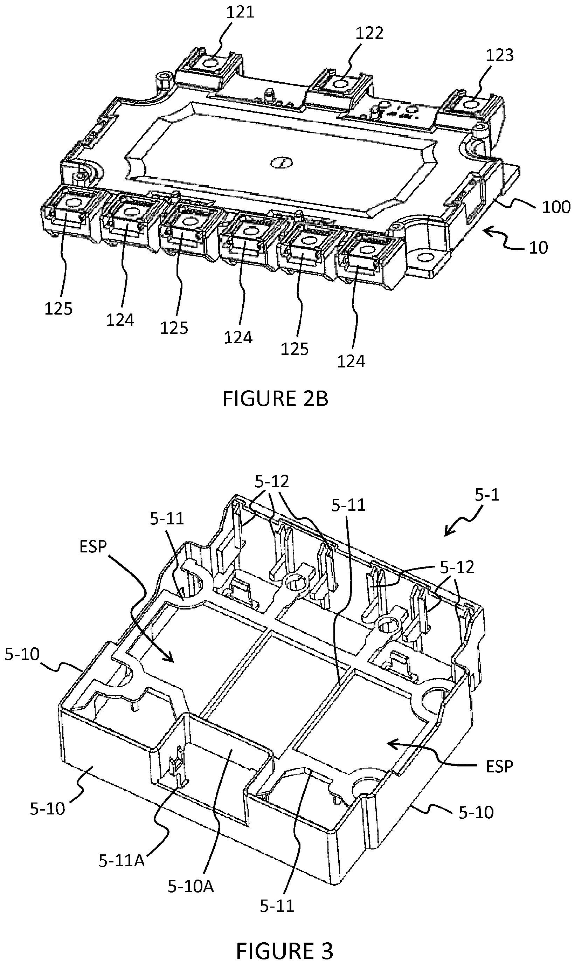

Dans l'exemple des figures 1 et 2, l'onduleur 1 comprend un boîtier 5 dans lequel sont montés un module électronique de puissance 10, une unité électronique de contrôle 20 et une pluralité de conducteurs électriques 30, 40, 111, 112, 113 fixés sur ledit module électronique de puissance 10.

En référence aux figures 1 à 3, le module électronique de puissance 10 comprend un corps 100 sur lequel sont fixés les conducteurs électriques 30, 40, 111, 112, 113. Par ailleurs, le module électronique de puissance 10 comprend des composants électroniques de puissance par lesquels passe l'énergie alimentant la machine électrique, notamment destinés à transformer le courant continu en courants alternatifs ou vice-versa. Ces composants électroniques de puissance peuvent comprendre des interrupteurs électroniques, tels que par exemple des transistors semi-conducteurs, agencés en circuit électrique pour permettre un passage commandé d'énergie électrique entre la batterie d'alimentation haute tension et la machine électrique. En particulier, les composants électroniques de puissance sont des puces semiconductrices nues pour lesquels le corps 100 réalise une encapsulation.

En référence à la figure 2B, le module électronique de puissance 10 comprend neuf bornes électriques externes, formant en particulier d'une part trois ports de phase 121, 122, 123 délivrant chacun un courant de phase de commande du moteur et d'autre part trois bornes électriques externes positives 124 et trois bornes électriques externes négatives 125.

En référence aux figures 1 et 2A, l'onduleur 1 comprend un premier conducteur électrique 30, destiné à relier électriquement l'onduleur 1 à la borne de potentiel positif de la batterie d'alimentation haute tension (non représentée), par exemple via un câble et un connecteur de batterie positif (non visibles). L'onduleur 1 comprend également un deuxième conducteur électrique 40, destiné à relier électriquement l'onduleur 1 à la borne de potentiel négatif de la batterie d'alimentation haute tension, par exemple via un câble et un connecteur de batterie positif (non visibles). L'onduleur 1 comprend également trois conducteurs dits « de phase » 111, 112, 113 destinés à relier électriquement le module électronique de puissance 10 à la machine électrique.

En référence à la figure 2A, chaque conducteur électrique 30, 40 se présente sous la forme d'une lame de laquelle s'étendent perpendiculairement trois éléments (ou points) de fixation 301, 401, 301-C, 401-C. Parmi ces trois éléments de fixation 301, 401, les deux éléments de fixation 301, 401 situés aux extrémités de la lame sont utilisés pour fixer le premier conducteur électrique 30 et le deuxième conducteur électrique 40 respectivement sur les bornes électriques externes positives 124 et sur les bornes électriques externes négatives 125 du module électronique de puissance 10 à l'aide d'une vis 131. Les deux éléments de fixation 301-C, 401-C centraux du conducteur électrique de potentiel positif 30 et du conducteur électrique de potentiel négatif 40 sont laissés libres et apparents afin de connecter ultérieurement les bornes positive et négative de la batterie d'alimentation haute tension via des câbles électriques (non représentés) fixés sur les deux éléments de fixation 301-C, 401-C centraux à l'aide d'une vis. Les deux éléments de fixation 301-C, 401-C centraux constituent ainsi des bornes apparentes, respectivement positive et négative, respectivement du premier conducteur électrique 30 et du deuxième conducteur électrique 40, ayant une double fonction de connexion électrique, entre les bornes électriques externes positives 124 et sur les bornes électriques externes négatives 125 du module électronique de puissance 10 et les bornes positive et négative de la batterie d'alimentation haute tension, et de fixation des câbles électriques des bornes positive et négative de la batterie d'alimentation haute tension sur le premier conducteur électrique 30 et sur le deuxième conducteur électrique 40.

Toujours en référence à la figure 2A, l'onduleur 1 comprend en outre une barre de fixation 50 électriquement isolante séparant le conducteur électrique de potentiel positif 30 du conducteur électrique de potentiel négatif 40, notamment afin de prévenir les courts-circuits entre le conducteur électrique de potentiel positif 30 et le conducteur électrique de potentiel négatif 40. A cette fin, la barre de fixation 50 est réalisée de préférence en un matériau plastique tel que, par exemple, du PBT GF30.

Chaque conducteur de phase 111, 112, 113 permet de connecter électriquement une phase de la machine électrique commandée par l'onduleur 1 avec le module électronique de puissance 10. On notera que, dans une autre forme de réalisation, l'onduleur 1 pourrait comprendre un nombre de conducteurs de phase 111, 112, 113 différent, notamment un nombre fonction du nombre de phases de la machine électrique commandée par l'onduleur 1. Chaque connecteur de phase 111, 112, 113 est monté sur un port de phase 121, 122, 123 correspondant du module électronique de puissance 10 par l'intermédiaire d'un moyen de fixation, par exemple une vis (non représentée). Chaque conducteur de phase 111, 112, 113 traverse une ouverture du boîtier 5 pour permettre de relier l'onduleur 1 à la machine électrique et notamment permettre la circulation des courants alternatifs entre le module électronique de puissance 10 et la machine électrique.

L'unité électronique de contrôle 20 comprend des composants pour contrôler les composants du module électronique de puissance 10. Plus précisément, l'unité électronique de contrôle 20 commande le module électronique de puissance 10 afin qu'il réalise la fonction de conversion du courant continu reçu de la batterie haute tension, définissant une tension continue entre le premier conducteur électrique 30 et le deuxième conducteur électrique 40, en trois courants de phase alternatifs de commande du moteur (ou vice-et-versa).

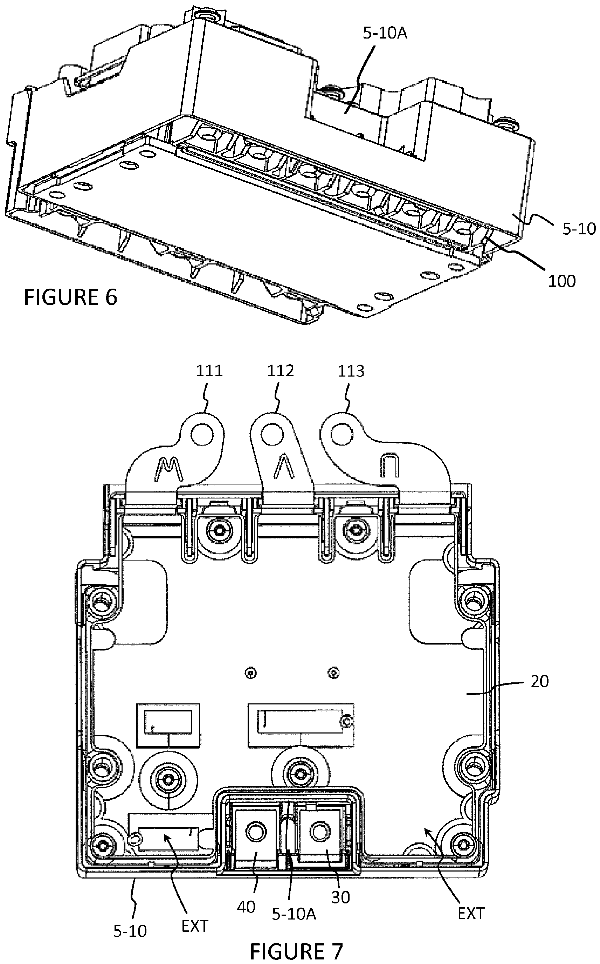

Comme illustré sur la figure 1, le boîtier 5 comprend un élément de boîtier 5-1 et un couvercle 5-2, monté sur l'élément de boîtier 5. L'onduleur 1 comprend un fond 6 s'étendant sous l'élément de boîtier 5-1 (figure 6). Dans l'exemple illustré à la figure 1, l'onduleur 1 comprend en outre, de manière non limitative, deux connecteurs de signaux 5-31, 5-32 et un connecteur d'alimentation 5-4, montés sur le couvercle 5-2 du boîtier 5. Les connecteurs de signaux 5-31, 5-32 sont destinés à permettre un échange de signaux de données entre les composants de l'onduleur 1 et l'extérieur de l'onduleur 1, par exemple avec un contrôleur du véhicule. En particulier, ces connecteurs de signaux 5-31, 5-32 peuvent être connectés à l'unité électronique de contrôle 20. Le connecteur d'alimentation 5-4, est destiné à connecter l'onduleur 1 à un câble d'alimentation électrique, par exemple relié au réseau électrique embarqué basse tension, afin de permettre l'alimentation électrique de l'unité électronique de contrôle 20

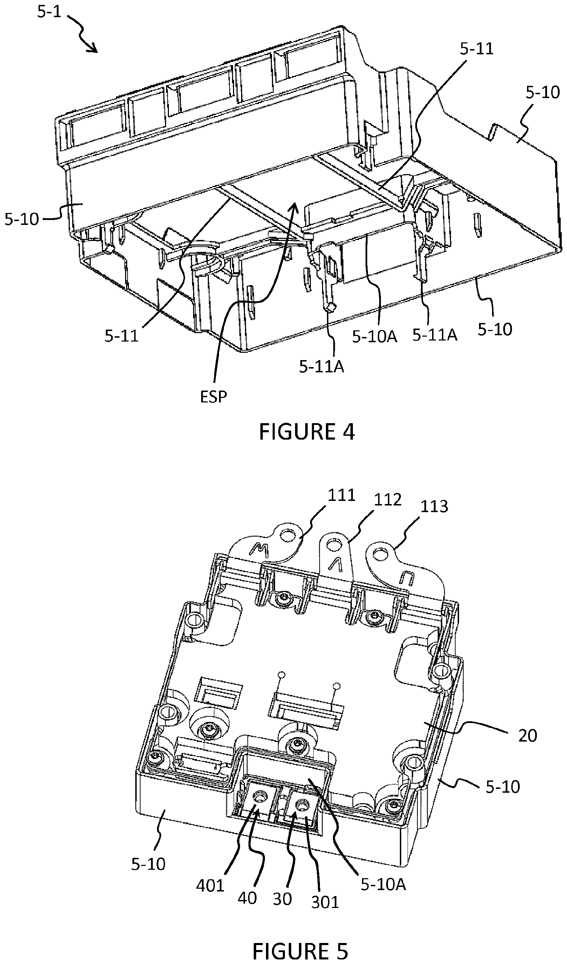

En référence désormais aux figures 3 et 4, l'élément de boîtier 5-1 se présente sous la forme d'une pièce monobloc réalisée par moulage d'un matériau plastique électriquement isolant. L'élément de boîtier 5-1 comprend une paroi latérale 5-10 se présentant sous la forme d'une ceinture en forme de U et des éléments de support 5-11 configurés pour recevoir le module électronique de puissance 10 et l'unité électronique de contrôle 20 lorsqu'ils sont montés dans ledit espace intérieur ESP. Dans cet exemple, les éléments de support 5-11 comprennent notamment des longerons 5-11A permettant de réceptionner le corps 100 du module électronique de puissance 10 et l'unité électronique de contrôle.

Toujours dans cet exemple, l'élément de boîtier 5 comprend des parois de blocage 5-12 permettant de monter les conducteurs de phase 111, 112, 113.

La paroi latérale 5-10 de l'élément de boîtier 5-1 comprend un déport de matière 5-10A vers son espace intérieur (ESP) formant une zone de connexion de la borne positive et de la borne négative de la batterie d'alimentation haute tension.

Comme illustré sur les figures 5 à 7, ce déport de matière 5-10A chevauche le premier conducteur électrique 30 et le deuxième conducteur électrique 40 en ne laissant apparaître, à l'extérieur de ladite paroi latérale 5-10, que l'élément de fixation 301-C, 401-C central de chacun des conducteurs électriques de potentiel 30, 40.

Dans l'exemple illustré et de manière non limitative, le déport de matière 5-10A est formé de sorte que la paroi 5-10 latérale présente en partie une forme de U. L'évidemment formé entre les branches du U, délimité par le déport de matière 5-10A de la paroi latérale 5-10 vers l'espace intérieur ESP, constituant la zone de connexion des bornes positives et négative de la batterie d'alimentation haute tension.

Le déport de matière 5-10A permet ainsi de limiter la zone visible et accessible à un opérateur des conducteurs électriques 30, 40 (zone de connexion) afin de réduire le risque de choc électrique tout en permettant l'utilisation de conducteurs électriques 30, 40 s'étendant sur toute la longueur d'un côté du boîtier 5. En effet, les surfaces de fixation des conducteurs électriques 30, 40 se trouvant dans l'espace intérieur ESP défini par la paroi latérale 5-10, elles ne sont plus accessibles pour un opérateur qui voit ainsi le risque de recevoir un choc électrique considérablement réduit. De plus, l'extension de la paroi latérale 5-10 du boîtier 5 de sorte à recouvrir les extrémités des conducteurs électriques 30, 40 permet de libérer des zones dites « d'extension » EXT au-dessus desdites extrémités, ce qui permet avantageusement d'étendre notamment la surface de la carte électronique de l'unité électronique de contrôle 20.

Lors de l'assemblage de l'onduleur 1, le premier conducteur électrique 30 et le deuxième conducteur électrique 40 sont tout d'abord montés sur la barre de support isolante 50 puis leurs éléments de fixation 301, 401 sont fixés aux bornes électriques externes positives 124 et sur les bornes électriques externes négatives 125 du module électronique de puissance 10 à l'aide de quatre vis 131.

Le corps 100 du module électronique de puissance 10 est ensuite positionné dans l'élément de boîtier 5-1.

Chaque conducteur de phase 111, 112, 113 est monté à force, par glissement entre chaque paire de parois 5-12A, 5-12B de sorte à être bloqués par les godrons entre la première paroi 5-12A et la deuxième paroi 5-12B de chaque paire de parois 5-12A, 5-12B, puis vissé sur le port de phase 121, 122, 123 correspondant de manière à le relier électriquement auxdits ports de phase 121, 122, 123 du module électronique de puissance 10.

L'unité électronique de contrôle 20 est ensuite montée sur le module électronique de puissance 10. Le couvercle 5-2 du boîtier 5 est ensuite être fixé sur l'élément de boîtier 5-1 de manière à fermer le boîtier 5. De même, le fond 6 est fixé sur le corps du module électronique de puissance 10 de manière à le recouvrir en partie, comme illustré sur la figure 6, afin notamment de limiter les risque pour un opérateur de recevoir un choc électrique en touchant le corps 100.

Les conducteurs de phase 111, 112, 113 de l'onduleur 1 peuvent ensuite être connectés électriquement à la machine électrique de même que les conducteurs électriques 30, 40 peuvent être connectés électriquement, via les bornes apparentes positive et négative, respectivement aux bornes de potentiel positif et négatif de la batterie d'alimentation haute tension du véhicule.

L'invention ne se limite pas au seul exemple décrit ci-dessus. Les figures représentent un exemple particulier de réalisation qui combine plusieurs modes de réalisation. Cependant, les caractéristiques liées aux modes de réalisation peuvent-être indépendantes entre elles d'un mode à l'autre, ou combinées entre elles, comme cela ressort des revendications.

## Revendications

1. Equipement électrique (1), notamment pour véhicule électrique ou hybride, comprenant un boîtier (5), ledit boîtier (5) comprenant un élément de boîtier (5-1) comprenant une paroi latérale (5-10) et définissant un espace intérieur (ESP) dans lequel sont montés :
- un module électronique de puissance (10) comprenant une pluralité de paires de bornes externes positive et négative (124, 125) destinées à échanger une énergie d'alimentation avec une source d'énergie électrique,
- une barre de connexion électrique comportant un premier conducteur électrique (30) et un deuxième conducteur électrique (40), le premier conducteur électrique (30) comprenant des bornes en contact avec les bornes positives du module électronique de puissance (10), de manière à mettre les bornes positives au même potentiel électrique par l'intermédiaire du premier conducteur électrique (30), le deuxième conducteur électrique (40) comprenant des bornes en contact avec les bornes négatives du module électronique de puissance (10), de manière à mettre les bornes négatives au même potentiel électrique par l'intermédiaire du deuxième conducteur électrique (40), au moins une desdites bornes du premier conducteur électrique (30), dite « borne apparente positive », et au moins une desdites bornes du deuxième conducteur électrique (40), dite « borne apparente négative », étant adaptées pour être reliées respectivement à une borne positive et à une borne négative d'une source d'énergie électrique,
équipement électrique (1) dans lequel la paroi latérale (5-10) de l'élément de boîtier (5-1) comprend un déport de matière (5-10A) vers son espace intérieur (ESP) formant une zone de connexion de la borne positive et de la borne négative de la source d'énergie électrique de sorte que ledit déport de matière (5-10A) chevauche le premier conducteur électrique (30) et le deuxième conducteur électrique (40) en ne laissant apparaître, de l'extérieur de ladite paroi latérale (5-10), que la borne apparente positive et la borne apparente négative.

2. Equipement électrique (1) selon la revendication précédente, dans lequel, la paroi latérale (5-10) présente au moins en partie une forme de U, le déport de matière (5-10A) formant la zone de connexion correspondant à l'évidemment situé entre les branches du U.

3. Equipement électrique (1) selon l'une des revendications précédentes, comprenant en outre une pluralité d'éléments de support (5-11) reliant entre elles une pluralité de portions de la paroi latérale (5-10) et permettant notamment le support du module électronique de puissance (10), du premier conducteur électrique (30) et du deuxième conducteur électrique (40).

4. Equipement électrique (1) selon l'une des revendications précédentes, ledit élément de boîtier (5-1) étant monobloc.

5. Equipement électrique (1) selon l'une des revendications précédentes, ledit élément de boîtier (5-1) étant réalisé en un matériau plastique.

6. Equipement électrique (1) selon l'une des revendications précédentes, dans lequel la barre de connexion électrique comprend en outre une barre de fixation (50) sur laquelle sont montés le premier conducteur électrique (30) et le deuxième conducteur électrique (40).

7. Equipement électrique (1) selon l'une des revendications précédentes, comprenant en outre un couvercle (5-2) fermant une face de la paroi latérale (5-10) de l'élément de boîtier (5-1).

8. Equipement électrique (1) selon l'une des revendications précédentes, comprenant en outre une unité électronique de contrôle (20), ladite unité électronique de contrôle (20) étant montée dans l'espace intérieur (ESP) défini par la paroi latérale (5-10) de l'élément de boîtier (5-1) et étant configurée pour contrôler le module électronique de puissance (10), notamment afin qu'il convertisse un courant continu en au moins un courant alternatif.

9. Equipement électrique (1) selon l'une des revendications précédentes, ledit équipement électrique étant un onduleur (1) destiné à être électriquement connecté, d'une part, à une machine électrique, notamment d'un véhicule électrique ou hybride et, d'autre part, à une batterie d'alimentation haute tension.

10. Equipement électrique (1) selon la revendication précédente, dans lequel le module électronique de puissance (10) est apte à convertir un courant continu en une pluralité de courants alternatifs dits « courants de phase ».

## Patentansprüche

1. Elektrische Ausrüstung (1), insbesondere für Elektro- oder Hybridfahrzeug, umfassend ein Gehäuse (5), wobei das Gehäuse (5) ein Gehäuseelement (5-1) umfasst, umfassend eine Seitenwand (5-10) und definierend einen Innenraum (ESP), in dem angebracht sind:
- ein elektronisches Leistungsmodul (10), umfassend eine Vielzahl von Paaren externer Klemmen, positiv und negativ (124, 125), die bestimmt sind, eine Versorgungsenergie mit einer Quelle elektrischer Energie auszutauschen,
- eine elektrische Anschlussleiste, aufweisend einen ersten elektrischen Leiter (30) und einen zweiten elektrischen Leiter (40), wobei der erste elektrische Leiter (30) Klemmen im Kontakt mit den positiven Klemmen des elektronischen Leistungsmoduls (10) derart umfasst, dass die positiven Klemmen über den ersten elektrischen Leiter (30) auf dasselbe elektrische Potential gebracht werden, wobei der zweite elektrische Leiter (40) Klemmen im Kontakt mit den negativen Klemmen des elektronischen Leistungsmoduls (10) derart umfasst, dass die negativen Klemmen über den zweiten elektrischen Leiter (40) auf dasselbe elektrische Potential gebracht werden, wobei mindestens eine der Klemmen des ersten elektrischen Leiters (30), bezeichnet als "sichtbare positive Klemme", und mindestens eine der Klemmen des zweiten elektrischen Leiters (40), bezeichnet als "sichtbare negative Klemme", geeignet sind, jeweils mit einer positiven Klemme und mit einer negativen Klemme einer Quelle elektrischer Energie verbunden zu sein,
elektrische Ausrüstung (1), wobei die Seitenwand (5-10) des Gehäuseelements (5-1) einen Materialversatz (5-10A) zu dessen Innenraum (ESP) umfasst, der eine Anschlusszone der positiven Klemme und der negativen Klemme der Quelle elektrischer Energie derart bildet, dass der Materialversatz (5-10A) den ersten elektrischen Leiter (30) und den zweiten elektrischen Leiter (40) überlappt, indem er von außerhalb der Seitenwand (5-10) nur die sichtbare positive Klemme und die sichtbare negative Klemme erscheinen lässt.

2. Elektrische Ausrüstung (1) nach vorangehendem Anspruch, wobei die Seitenwand (5-10) mindestens teilweise eine U-Form aufweist, wobei der Materialversatz (5-10A) die Anschlusszone bildet, die der Aussparung zwischen den Schenkeln des U entspricht.

3. Elektrische Ausrüstung (1) nach einem der vorangehenden Ansprüche, umfassend ferner eine Vielzahl von Trägerelementen (5-11), die zwischen sich eine Vielzahl von Abschnitten der Seitenwand (5-10) verbinden und insbesondere das Tragen des elektronischen Leistungsmoduls (10), des ersten elektrischen Leiters (30) und des zweiten elektrischen Leiters (40) erlauben.

4. Elektrische Ausrüstung (1) nach einem der vorangehenden Ansprüche, wobei das Gehäuseelement (5-1) einteilig ist.

5. Elektrische Ausrüstung (1) nach einem der vorangehenden Ansprüche, wobei das Gehäuseelement (5-1) aus einem Kunststoffmaterial hergestellt ist.

6. Elektrische Ausrüstung (1) nach einem der vorangehenden Ansprüche, wobei die elektrische Anschlussleiste ferner eine Befestigungsleiste (50) umfasst, auf der der erste elektrische Leiter (30) und der zweite elektrische Leiter (40) angebracht sind.

7. Elektrische Ausrüstung (1) nach einem der vorangehenden Ansprüche, umfassend ferner einen Deckel (5-2), der eine Seite der Seitenwand (5-10) des Gehäuseelements (5-1) verschließt.

8. Elektrische Ausrüstung (1) nach einem der vorangehenden Ansprüche, umfassend ferner eine elektronische Steuereinheit (20), wobei die elektronische Steuereinheit (20) im von der Seitenwand (5-10) des Gehäuseelements (5-1) festgelegten Innenraum (ESP) angebracht ist und ausgelegt ist, um das elektronische Leistungsmodul (10) zu steuern, insbesondere damit es einen Gleichstrom in mindestens einen Wechselstrom umwandelt.

9. Elektrische Ausrüstung (1) nach einem der vorangehenden Ansprüche, wobei die elektrische Ausrüstung ein Wechselrichter (1) ist, der bestimmt ist, zum einen an eine elektrische Maschine, insbesondere eines Elektro- oder Hybridfahrzeugs, und zum anderen an eine Hochspannungs-Versorgungsbatterie elektrisch angeschlossen zu sein.

10. Elektrische Ausrüstung (1) nach vorangehendem Anspruch, wobei das elektronische Leistungsmodul (10) imstande ist, einen Gleichstrom in eine Vielzahl von Wechselströmen, bezeichnet als "Phasenströme", umzuwandeln.

## Claims

1. Electrical equipment (1), in particular for electrical or hybrid vehicles, comprising a casing (5), said casing (5) comprising a casing element (5-1) comprising a side wall (5-10) and defining an inner space (ESP) wherein are mounted:
- an electronic power module (10) comprising a plurality of pairs of outer positive and negative terminals (124, 125) configured to exchange a supply energy with an electrical energy source,
- an electrical connection bar comprising a first electrical conductor (30) and a second electrical conductor (40), the first electrical conductor (30) comprising terminals in contact with the positive terminals of the electronic power module (10), so as to put the positive terminals at the same electrical potential by way of the first electrical conductor (30), the second electrical conductor (40) comprising terminals in contact with the negative terminals of the electronic power module (10), so as to put the negative terminals at the same electrical potential by way of the second electrical conductor (40), at least one of said terminals of the first electrical conductor (30), called "positive apparent terminal", and at least one of said terminals of the second electrical conductor (40), called "negative apparent terminal", being adapted to be connected respectively to a positive terminal and a negative terminal of an electrical energy source,
electrical equipment (1) wherein the side wall (5-10) of the casing element (5-1) comprises a material offset (5-10A) towards the inner space (ESP) thereof forming a zone for connecting the positive terminal and the negative terminal of the electrical energy source such that said material offset (5-10A) overlaps the first electrical conductor (30) and the second electrical conductor (40) by only making visible, from the outside of said side wall (5-10), the positive apparent terminal and the negative apparent terminal.

2. Electrical equipment (1) according to the preceding claim, wherein, the side wall (5-10) has at least partially a U-shape, the material offset (5-10A) forming the connection zone corresponding to the recess situated between the U-shaped branches.

3. Electrical equipment (1) according to one of the preceding claims, further comprising a plurality of support elements (5-11) connecting between them, a plurality of portions of the side wall (5-10) and making it possible in particular for the support of the electronic power module (10), the first electrical conductor (30) and the second electrical conductor (40).

4. Electrical equipment (1) according to one of the preceding claims, said casing element (5-1) being one-piece.

5. Electrical equipment (1) according to one of the preceding claims, said casing element (5-1) being made of a plastic material.

6. Electrical equipment (1) according to one of the preceding claims, wherein the electrical connection bar further comprises an attachment bar (50) on which are mounted the first electrical conductor (30) and the second electrical conductor (40).

7. Electrical equipment (1) according to one of the preceding claims, further comprising a cover (5-2) closing a face of the side wall (5-10) of the casing element (5-1).

8. Electrical equipment (1) according to one of the preceding claims, further comprising an electronic control unit (20), said electronic control unit (20) being mounted in the inner space (ESP) defined by the side wall (5-10) of the casing element (5-1) and being configured to control the electronic power module (10), in particular such that it converts a direct current into at least one alternating current.

9. Electrical equipment (1) according to one of the preceding claims, said electrical equipment being an inverter (1) configured to be electrically connected, on the one hand, to an electrical machine, in particular of an electrical or hybrid vehicle and, on the other hand, to a high voltage supply battery.

10. Electrical equipment (1) according to the preceding claim, wherein the electronic power module (10) is capable of converting a direct current into a plurality of alternating currents called "phase currents".
